# EUROPEAN PATENT SPECIFICATION

(11) **EP 4 579 995 B1**
(45) Date of publication and mention of the grant of the patent: **14.10.2026**
(21) Application number: 24753543.8
(22) Date of filing: 31.01.2024
(51) Int. Cl.: H02J 7/50, H02J 7/54, H02J 7/82, H02J 7/96, H01M 10/44

(54) **BATTERY MANAGEMENT APPARATUS AND METHOD, AND BATTERY PACK INCLUDING BATTERY MANAGEMENT APPARATUS**
BATTERIEVERWALTUNGSVORRICHTUNG UND -VERFAHREN SOWIE BATTERIEPACK DAMIT
DISPOSITIF ET PROCÉDÉ DE GESTION DE BATTERIE ET BLOC-BATTERIE LES COMPRENANT

(30) Priority: 10.02.2023 KR 20230018298
(43) Date of publication of application: 02.07.2025
(73) Proprietor: LG Energy Solution, Ltd., Seoul 07335 (KR)
(72) Inventor: KIM, Young-Deok, Daejeon 34122 (KR); KIM, Dae-Soo, Daejeon 34122 (KR); CHOI, Soon-Ju, Daejeon 34122 (KR)
(74) Representative: Plasseraud IP
(86) International application number: PCT/KR2024/001478
(87) International publication number: WO 2024/167214

(56) References cited:
- JP-A- 2018 127 977
- JP-A- 2018 127 977
- JP-A- 2020 053 240
- KR-A- 20170 050 507
- KR-A- 20200 086 960
- KR-A- 20220 117 040
- KR-A- 20220 117 040
- KR-B1- 102 330 260
- KR-B1- 102 330 260
- US-A1- 2020 235 588

## Description

### TECHNICAL FIELD

The present disclosure relates to a battery management apparatus, a battery management method, and a battery pack including the battery management apparatus.

### BACKGROUND

Recently, the demand for portable electronics including laptops, video cameras, and mobile phones has increased dramatically, and the development of electric vehicles, energy storage batteries, robots, and satellites has accelerated. Under the circumstances, research is being actively conducted on high-performance rechargeable batteries.

Presently, commercially available batteries include nickel-cadmium batteries, nickel-hydrogen batteries, nickel-zinc batteries, and lithium batteries. Of these batteries, lithium batteries are emerging as the most popular, as they do not suffer from the memory effect and therefore are freely rechargeable, have low self-discharge rates, and have high energy density, as compared to nickel-based batteries.

In graphite-based batteries, the staging phenomenon may occur as lithium is intercalated into graphite layers. In the staging phenomenon related to the lithium intercalation reaction, a transition from a high stage to a low stage is observed as the lithium insertion concentration increases. In contrast, in a lithium deintercalation reaction (discharge reaction), the transition takes place in reverse.

An SOC (state of charge) band in which the graphite staging phenomenon occurs may be referred to as a staging band. Degradation of batteries may be accelerated when charged and discharged in the staging band, as compared to when charged and discharged outside the staging band. For example, batteries that have been continuously charged and discharged in the staging band may degrade more quickly than batteries that have not been charged and discharged in the staging band.

Therefore, the development of technologies for improving the life expectancy of batteries by limiting the charge and discharge in the band that may affect the degradation of batteries is required.

Example of background art can be found in documents US 2020/235588 A1, KR 2017 0050507 A, KR 102 330 260 B1 and JP 2018 127977 A.

### SUMMARY

The present disclosure is designed to solve the above problems, and the present disclosure provides a battery management apparatus and a battery management method for controlling the charge and discharge of batteries to extend the life of the batteries, and a battery pack including the battery management apparatus.

Advantages of the present disclosure may be understood from the descriptions herein below, and may more clearly be comprehended from embodiments of the present disclosure. Further, it will be apparent that the objects and advantages of the present disclosure may be implemented by the means defined in the claims and combinations thereof.

According to an aspect of the present disclosure, a battery management apparatus is defined in the independent claim 1

According to another aspect of the present disclosure, a battery pack is provided.

According to yet another aspect of the present disclosure, a battery management method is provided, as defined in the independent claim 11.

The effects of the present disclosure are not limited to the effects mentioned above, and other effects not mentioned will be clearly understood by those skilled in the art from the claims.

### BRIEF DESCRIPTION OF THE DRAWINGS

Since the drawings attached herewith serve to facilitate the understanding of the technical idea of the present disclosure in conjunction with the detailed description of the invention herein below, the present disclosure should not be construed as being limited to the matters illustrated in the drawings.
FIG. 1 is a view schematically illustrating a battery management apparatus according to an embodiment of the present disclosure.
FIG. 2 is a view schematically illustrating an example of a configuration of a battery pack according to another embodiment of the present disclosure.
FIGS. 3 to 7 are diagrams illustrating Example 1 according to the present disclosure.
FIGS. 8 to 12 are diagrams illustrating Example 2 according to the present disclosure.
FIG. 13 is a flow diagram schematically illustrating a battery management method according to yet another embodiment of the present disclosure.

### DETAILED DESCRIPTION

Words and terms used in the detailed description and the claims herein should not be interpreted to be limited to their usual or dictionary meanings, but should be interpreted to have meanings and concepts that correspond to the technical idea of the present disclosure in compliance with the principle that inventors may appropriately define terms and concepts for the purpose of best describing the present disclosure.

Thus, it can be appreciated that the embodiments described herein and the configurations illustrated in the drawings are merely example embodiments of the present disclosure, which do not exhaustively represent the technical idea of the present disclosure, and various equivalents and modifications may be made to substitute the present disclosure at the time of filing the present disclosure. However, the scope of the invention is solely defined by the appended claims.

Further, when describing the present disclosure, detailed description of related well-known configurations or functions may be omitted if determined to obscure the gist of the present disclosure.

Terms with ordinal numbers such as first, second and so on may be used to discriminate various components from one another, and should not be interpreted as limiting the components.

Throughout the descriptions herein, when a certain part "includes" a specific component, this description does not indicate that the certain part excludes other components, but indicates that the part may further include other components, unless otherwise defined.

Further, throughout the descriptions herein, when two components are "connected" to each other, this description indicates not only that the two components are "directly connected" to each other, but also that the two components are "indirectly connected" to each other via another component.

Hereinafter, embodiments of the present disclosure will be described in detail with reference to the accompanying drawings.

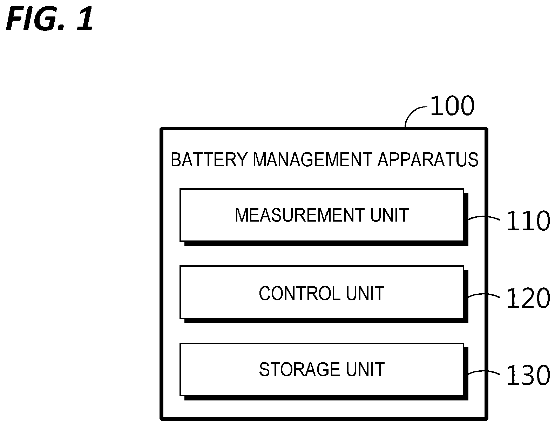

FIG. 1 is a view schematically illustrating a battery management apparatus 100 according to an embodiment of the present disclosure.

Referring to FIG. 1, the battery management apparatus 100 may include a measurement unit 110 and a control unit 120.

The measurement unit 110 may be configured to measure voltages of a plurality of batteries B connected, for example, in series to each other.

Here, each battery indicates a single independent cell that is physically separable with an anode terminal and a cathode terminal included therein. For example, the battery may be a lithium ion battery or a lithium polymer battery. Further, the battery may indicate a battery module including a plurality of cells connected in series and/or parallel to each other. Hereinafter, for the convenience of description, it is assumed that the battery indicates a single independent cell.

The measurement unit 110 may be connected to the control unit 120 for a communication with the control unit 120. The measurement unit 110 may measure the voltage of each of the plurality of batteries B, and transmit information of the measured voltage to the control unit 120.

The control unit 120 may be configured to estimate the SOC (state of charge) of each of the plurality of batteries B based on the voltage received from the measurement unit 110.

For example, the control unit 120 may estimate the SOC from the voltage of each of the plurality of batteries B by using a table (*e.g.,* a look up table (LUT)) representing an association relationship between voltages and SOCs. The table may be initially set based on batteries in the BOL (beginning of life) state. The table may be updated to correspond to the degrading states of the plurality of batteries B. For example, the updated table may represent the association relationship between the voltages and the SOCs of the degrading batteries.

The control unit 120 may be configured to control the charge and discharge of the plurality of batteries B such that the SOCs of the plurality of batteries B fall within a plurality of usable SOC bands set in advance to correspond to the plurality of batteries B.

The usable SOC bands may be set based on preset non-usable SOC bands. Further, the usable SOC bands may be set to not overlap with each other. For example, the non-usable SOC bands may be SOC bands preset to be unusable because the degradation of batteries may be accelerated during the charge and discharge in the non-usable SOC bands. As an example, the non-usable SOC bands may include an SOC band including 90 % to 100 % SOC in which a battery is fully charged, an SOC band including 0 % to 10 % SOC in which a battery is fully discharged, and an SOC band known as the graphite staging band. These are merely examples, and the non-usable SOC bands may be further set through experiments on whether the battery degradation is accelerated.

The control unit 120 may set the plurality of usable SOC bands based on the preset non-usable SOC bands. Then, the control unit 120 may set a usable SOC band corresponding to each of the plurality of batteries B.

For example, it is assumed that four batteries B1 to B4 are provided, and a first usable SOC band U1 and a second usable SOC band U2 are set. The control unit 120 may set a first battery B1 and a second battery B2 to correspond to the first usable SOC band U1. The control unit 120 may set a third battery B3 and a fourth battery B4 to correspond to the second usable SOC band U2. For example, the control unit 120 may set arbitrary usable SOC bands corresponding to the plurality of batteries B, regardless of the current SOCs or voltages of the plurality of batteries B.

The control unit 120 may be configured to control the charge and discharge of the plurality of batteries B such that the SOCs of the plurality of batteries B fall within their corresponding usable SOC bands.

Specifically, the control unit 120 may control the charge and discharge of each of the plurality of batteries B such that the SOC of each of the plurality of batteries B falls within its corresponding usable SOC band.

For example, when the SOC of a certain battery reaches a lower limit value of the usable SOC band corresponding to the battery, the control unit 120 may terminate the discharge of the battery. Meanwhile, when the SOC of another battery reaches an upper limit value of the usable SOC band corresponding to the battery, the control unit 120 may terminate the charge of the battery.

That is, the battery management apparatus 100 may control the charge and discharge of the plurality of batteries B such that the SOCs of the plurality of batteries B do not fall in the non-usable SOC bands. According to the present disclosure, the life expectancy of the plurality of batteries B is extended.

Meanwhile, the control unit 120 of the battery management apparatus 100 may selectively include, for example, a processor, an application-specific integrated circuit (ASIC), other chipsets, logic circuits, registers, a communication modem, and a data processor, which are well-known in the art, to execute various control logics according to the present disclosure. When control logics are implemented by software, the control unit 120 may be implemented as a set of program modules. At this time, the program modules may be stored in a memory, and executed by the control unit 120. The memory may be provided inside or outside the control unit 120, and connected to the control unit 120 as any of various well-known means.

The battery management apparatus 100 may further include a storage unit 130. The storage unit 130 may store, for example, data or programs necessary when each component of the battery management apparatus 100 performs its operation and function, and data and the like generated during the performance of the operation and function. The type of the storage unit 130 is not particularly limited as long as the storage unit 130 is a known information storing means in which recording, erasing, updating, and reading of data may be performed. Examples of the information storing means may include a RAM, a flash memory, a ROM, an EEPROM, and a register. Further, the storage unit 130 may store program codes that define processes executable by the control unit 120.

For example, the storage unit 130 may store information of the non-usable SOC bands, information of the usable SOC bands, and information of the association relationship between the plurality of usable SOC bands and the plurality of batteries.

The control unit 120 may be configured to control the operation state of a bypass switch S disposed in a bypass path connected in parallel to each of the plurality of batteries B, thereby controlling the charge and discharge of the plurality of batteries B.

Specifically, the plurality of batteries B may be connected in series to each other. Thus, the bypass switch S may be connected in parallel to each of the plurality of batteries B, for the charge and discharge control by the control unit 120. By controlling the operation state of the bypass switch S to an ON or OFF state, the control unit 120 may control the charge and discharge of the plurality of batteries B.

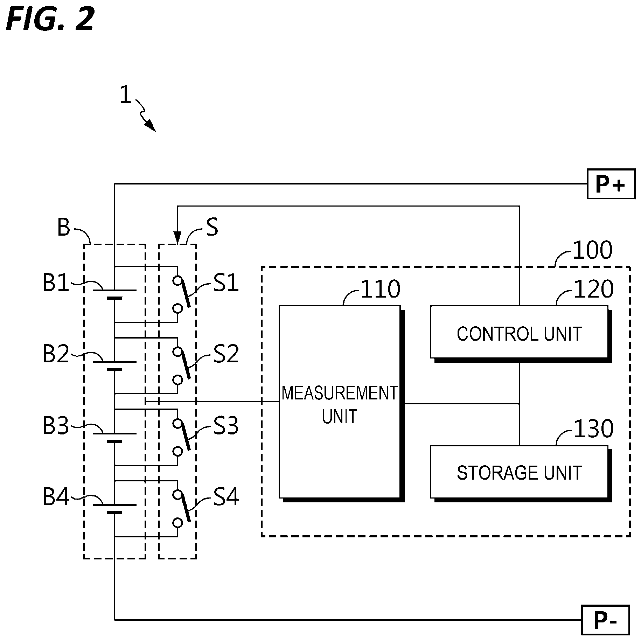

FIG. 2 is a view schematically illustrating an example of a configuration of a battery pack 1 according to another embodiment of the present disclosure.

In the embodiment of FIG. 2, the plurality of batteries B may include a first battery B1, a second battery B2, a third battery B3, and a fourth battery B4. A plurality of bypass switches S may include a first bypass switch S1, a second bypass switch S2, a third bypass switch S3, and a fourth bypass switch S4. The first bypass switch S1 may be connected in parallel to the first battery B1, and the second bypass switch S2 may be connected in parallel to the second battery B2. The third bypass switch S3 may be connected in parallel to the third battery B3, and the fourth bypass switch S4 may be connected in parallel to the fourth battery B4.

In the process of charging the plurality of batteries B, the control unit 120 may be configured to select a target battery of which SOC reaches the upper limit value of the usable SOC band corresponding to the target battery, during the charge of the plurality of batteries B. The control unit 120 may be configured to control the operation state of the bypass switch S connected in parallel to the target battery to the ON state.

For example, in the embodiment of FIG. 2, it may be assumed that the SOC of the first battery B1 reaches the upper limit value of the corresponding usable SOC band, and the SOCs of the second battery B2, the third battery B3, and the fourth battery B4 do not reach the upper limit values of the corresponding usable SOC bands. The control unit 120 may select the first battery B1 as a target battery. Then, the control unit 120 may control the operation state of the first bypass switch S1 to the ON state, and the operation states of the second bypass switch S2, the third bypass switch S3, and the fourth bypass switch S4 to the OFF state. In this case, the charge of the first battery B1 is terminated, and the charge of the second battery B2, third battery B3, and fourth battery B4 may continue.

Meanwhile, in the process of discharging the plurality of batteries B, the control unit 120 may be configured to select a target battery of which SOC reaches the lower limit value of the usable SOC band corresponding to the target battery, during the discharge of the plurality of batteries B. The control unit 120 may be configured to control the operation state of the bypass switch S connected in parallel to the target battery to the ON state.

For example, in the embodiment of FIG. 2, it may be assumed that the SOCs of the second battery B2 and the fourth battery B4 reach the lower limit values of the corresponding usable SOC bands, and the SOCs of the first battery B1 and the third battery B3 do not reach the lower limit values of the corresponding usable SOC bands. The control unit 120 may select the second battery B2 and the fourth battery B4 as target batteries. Then, the control unit 120 may control the operation states of the second bypass switch S2 and the fourth bypass switch S4 to the ON state, and the operation states of the first bypass switch S1 and the third bypass switch S3 to the OFF state. In this case, the discharge of the second battery B2 and the fourth battery B4 may be terminated, and the discharge of the first battery B1 and the third battery B3 may continue.

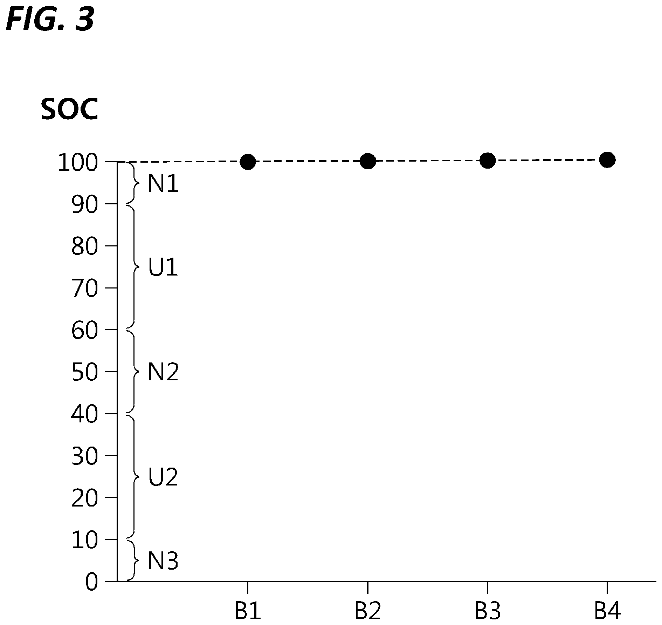

FIGS. 3 to 7 are diagrams illustrating Example 1 according to the present disclosure.

Hereinafter, Example 1 will be described, assuming that the SOC range of above 90 % and 100 % or lower is set as a first non-usable SOC band N1, the SOC range of 60 % to 90 % is set as a first usable SOC band U1, the SOC range of above 40 % and below 60 % is set as a second non-usable SOC band N2, the SOC range of 10 % to 40 % is set as a second usable SOC band U2, and the SOC range of 0 % or more and below 10 % is set as a third non-usable SOC band N3. Further, it is assumed that the first battery B1 and the second battery B2 are set to correspond to the first usable SOC band U1, and the third battery B3 and the fourth battery B4 are set to correspond to the second usable SOC band U2.

In the Example of FIG. 3, the first battery B1, the second battery B2, the third battery B3, and the fourth battery B4 may be initially in the fully charged state. For example, the SOCs of the first battery B1, the second battery B2, the third battery B3, and the fourth battery B4 may be 100 %.

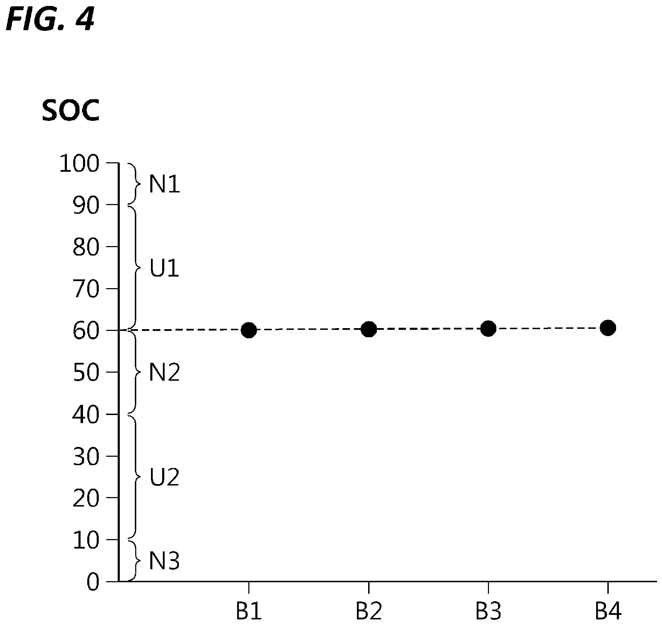

In the Example of FIG. 4, the first battery B1, the second battery B2, the third battery B3, and the fourth battery B4 may be discharged. The SOCs of the first battery B1, the second battery B2, the third battery B3, and the fourth battery B4 may reach 60 %, which is the lower limit value of the first usable SOC band U1.

Since the SOCs of the first battery B1 and the second battery B2 reach the lower limit value of the first usable SOC band U1, the control unit 120 may set the first battery B1 and the second battery B2 as target batteries. Then, the control unit 120 may terminate the discharge of the first battery B1 and the second battery B2, and continue the discharge of the third battery B3 and the fourth battery B4.

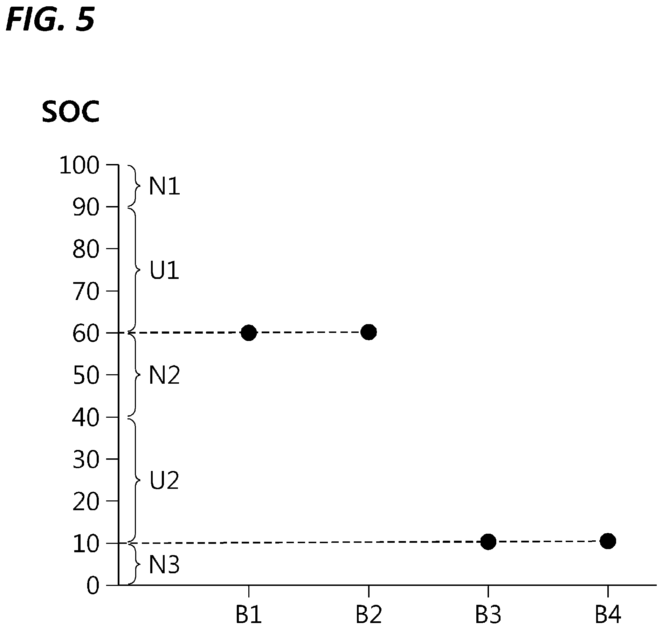

In the Example of FIG. 5, the third battery B3 and the fourth battery B4 may continue to be discharged. The SOCs of the third battery B3 and the fourth battery B4 may reach 10 %, which is the lower limit value of the second usable SOC band U2.

Then, the control unit 120 may control the charge and discharge of the first battery B1 and the second battery B2 within the first usable SOC band U1, and the charge and discharge of the third battery B3 and the fourth battery B4 within the second usable SOC band U2.

When the discharge of the plurality of batteries B is requested despite that the SOCs of the plurality of batteries B have reached the lower limit values of their corresponding usable SOC bands, the control unit 120 may rank priorities among the plurality of usable SOC bands in a decreasing order of a band value. Then, the control unit 120 may discharge the batteries in a decreasing order of the priorities.

Specifically, the control unit 120 may discharge the plurality of batteries B while terminating the discharge of the target batteries of which SOCs reach the lower limit values of the usable SOC bands corresponding to the target batteries. Even when the discharge of all of the plurality of batteries B is terminated, the discharge request may be made continuously. In this case, the control unit 120 may set the priorities among the usable SOC bands based on band values of the plurality of usable SOC bands.

Here, the band value refers to a value included in a corresponding usable SOC band, and may be, for example, the upper limit value, the lower limit value, a mean value, or a median value of the corresponding usable SOC band. Since the plurality of usable SOC bands do not overlap with each other, the band values of the plurality of usable SOC bands may not also overlap with each other.

For example, in the Example of FIG. 5, the SOCs of all of the first battery B 1, the second battery B2, the third battery B3, and the fourth battery B4 reach the lower limit values of their corresponding usable SOC bands. Under the normal circumstances, the discharge of all of the first battery B1, the second battery B2, the third battery B3, and the fourth battery B4 needs to be terminated. However, since the first battery B1 and the second battery B2 may be further discharged, the discharge request may be continued.

Since the band value of the first usable SOC band U1 is larger than the band value of the second usable SOC band U2, the control unit 120 may set a higher priority for the first usable SOC band U1 than that for the second usable SOC band U2. Then, the control unit 120 may further discharge the first battery B1 and the second battery B2 that correspond to the first usable SOC band U1.

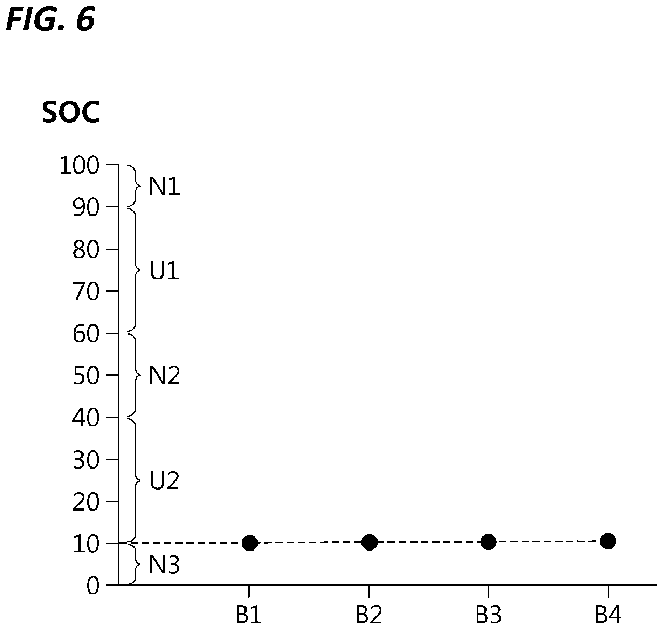

For example, in the Example of FIG. 6, the SOCs of the first battery B1 and the second battery B2 may reach the lower limit value of the second usable SOC band U2. Then, the control unit 120 may terminate the discharge of the first battery B1, the second battery B2, the third battery B3, and the fourth battery B4.

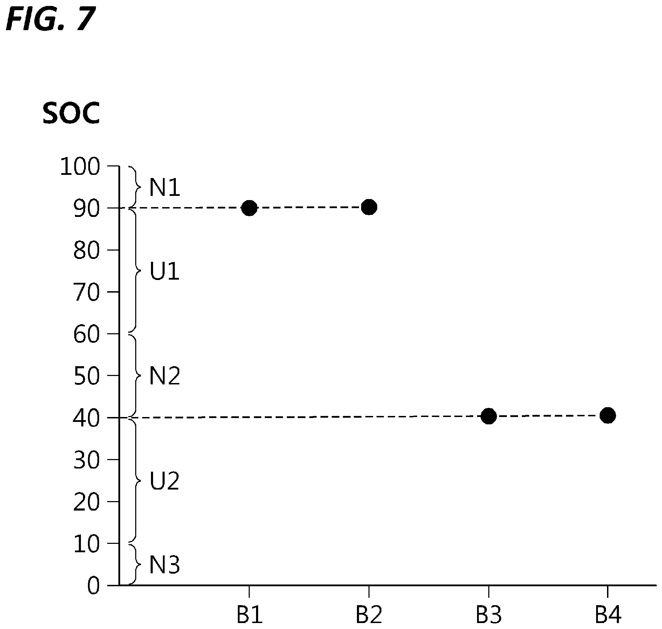

Thereafter, during the charge process in the Example of FIG. 7, the first battery B1 and the second battery B2 may be charged until their SOCs reach the upper limit value of the first usable SOC band U1, and the third battery B3 and the fourth battery B4 may be charged until their SOCs reach the upper limit value of the second usable SOC band U2. Then, the control unit 120 may control the charge and discharge of the first battery B1 and the second battery B2 within the first usable SOC band U1, and the charge and discharge of the third battery B3 and the fourth battery B4 within the second usable SOC band U2.

The battery management apparatus 100 according to an embodiment of the present disclosure may extend the life expectancy of a battery by controlling the charge and discharge of the battery within its corresponding usable SOC band. When the additional discharge of a battery is necessary, the battery management apparatus 100 may further discharge the battery.

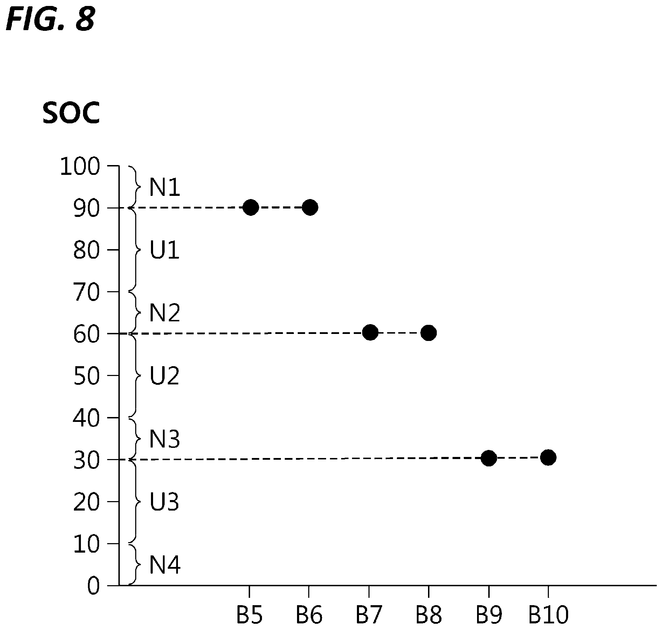

FIGS. 8 to 12 are diagrams illustrating Example 2 according to the present disclosure.

Hereinafter, Example 2 will be described, assuming that the SOC range of above 90 % and 100 % or lower is set as a first non-usable SOC band N1, the SOC range of 70 % to 90 % is set as a first usable SOC band U1, the SOC range of above 60 % and below 70 % is set as a second non-usable SOC band N2, the SOC range of 40 % to 60 % is set as a second usable SOC band U2, the SOC range of above 30 % and below 40 % is set as a third non-usable SOC band N3, the SOC range of 10 % to 30 % is set as a third usable SOC band U3, and the SOC range of 0 % or higher and below 10 % is set as a fourth non-usable SOC band N4. Further, it is assumed that a fifth battery B5 and a sixth battery B6 are set to correspond to the first usable SOC band U1, a seventh battery B7 and an eighth battery B8 are set to correspond to the second usable SOC band U2, and a ninth battery B9 and a tenth battery B10 are set to correspond to the third usable SOC band U3.

The usable SOC bands and the non-usable SOC bands illustrated in FIGS. 7 and 8 are bands arbitrarily selected for the convenience of description. Thus, buffer bands set appropriately through experiments (SOC bands for preventing the full charge and the full discharge) and the graphite staging band may be set as non-usable SOC bands. Then, usable SOC bands may be set according to the set non-usable SOC bands. For example, the usable SOC bands and the non-usable SOC bands are not limited to those in the Examples of FIGS. 7 and 8.

In the Example of FIG. 8, the SOCs of the fifth battery B5 and the sixth battery B6 are 90 %, which may be the same as the upper limit value of the first usable SOC band U1. The SOCs of the seventh battery B7 and the eighth battery B8 are 60 %, which may be the same as the upper limit value of the second usable SOC band U2. The SOCs of the ninth battery B9 and the tenth battery B10 are 30 %, which may be the same as the upper limit value of the third usable SOC band U3.

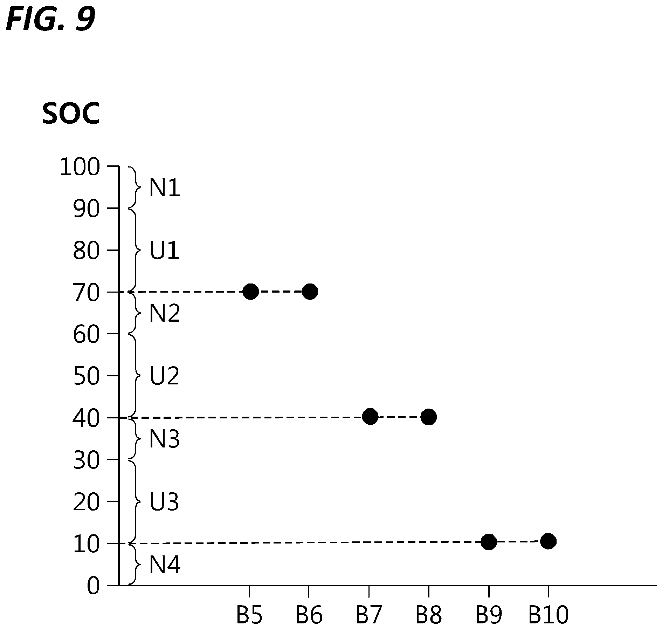

In the Example of FIG. 9, the fifth battery B5, the sixth battery B6, the seventh battery B7, the eighth battery B8, the ninth battery B9, and the tenth battery B10 may be discharged. The SOCs of the fifth battery B5 and the sixth battery B6 are 70 %, which may be the same as the lower limit value of the first usable SOC band U1. The SOCs of the seventh battery B7 and the eighth battery B8 are 40 %, which may be the same as the lower limit value of the second usable SOC band U2. The SOCs of the ninth battery B9 and the tenth battery B10 are 10 %, which may be the same as the lower limit value of the third usable SOC band U3.

Then, when the discharge request is continued, the control unit 120 may set priorities of the usable SOC bands in the order of the first usable SOC band U1, the second usable SOC band U2, and the third usable SOC band U3, which rank in an order from the highest band value to the lowest band value.

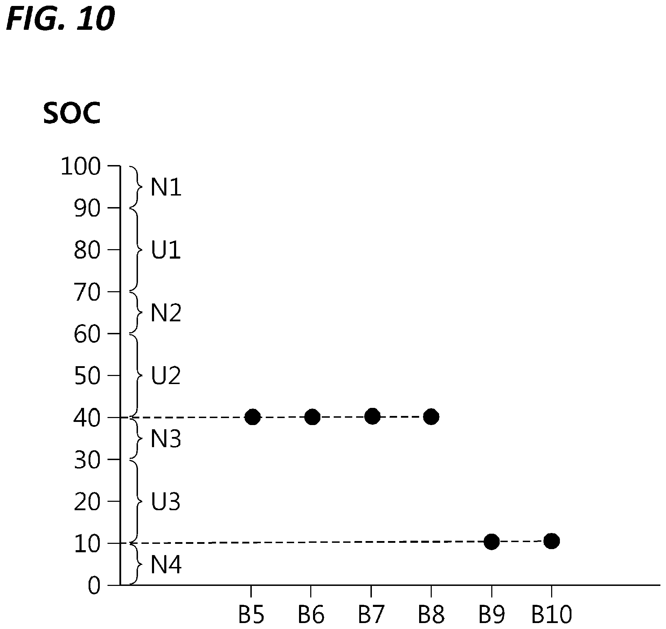

For example, in the Example of FIG. 10, the fifth battery B5 and the sixth battery B6 are further discharged, and the SOCs of the fifth battery B5 and the sixth battery B6 may reach the lower limit value of the second usable SOC band U2. Here, when the fifth battery B5 and the sixth battery B6 are further discharged, the fifth battery B5 and the sixth battery B6 may be discharged even in the third non-usable SOC band N3. In this case, the plurality of batteries B may degrade in disequilibrium.

In order to help the plurality of batteries B degrade in equilibrium, the control unit 120 may be configured such that, when the SOCs of batteries being discharged reach the lower limit value of the usable SOC band with the subsequent priority, batteries corresponding to the usable SOC band with the subsequent priority are discharged.

For example, in the Example of FIG. 10, the SOCs of the fifth battery B5, the sixth battery B6, the seventh battery B7, and the eighth battery B8 are 40 %, which may be the same as the lower limit value of the second usable SOC band U2. When the discharge request continues, the control unit 120 may discharge the seventh battery B7 and the eighth battery B8 that correspond to the second usable SOC band U2 with the subsequent priority.

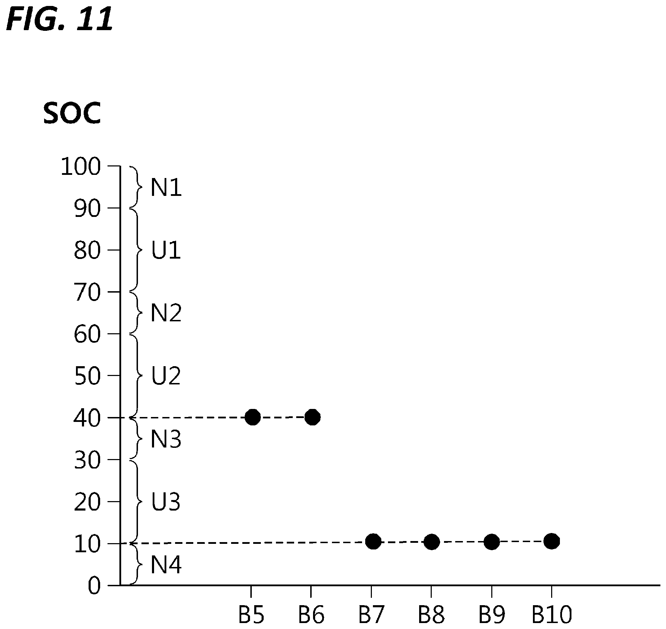

For example, in the Example of FIG. 11, the seventh battery B7 and the eighth battery B8 may be discharged. For example, the seventh battery B7 and the eighth battery B8 may be 10 % SOC, which may be the same as the lower limit value of the third usable SOC band U3. Accordingly, the SOCs of the seventh battery B7, the eighth battery B8, the ninth battery B9, and the tenth battery B10 may be the same as the lower limit value of the third usable SOC band U3.

It is assumed that the discharge request is continued even thereafter. In this case, since the ninth battery B9 and the tenth battery B10, which correspond to the third usable SOC band U3 with the last priority, may no longer be discharged, the fifth battery B5 and the sixth battery B6, which correspond to the first usable SOC band U1, may be discharged further again.

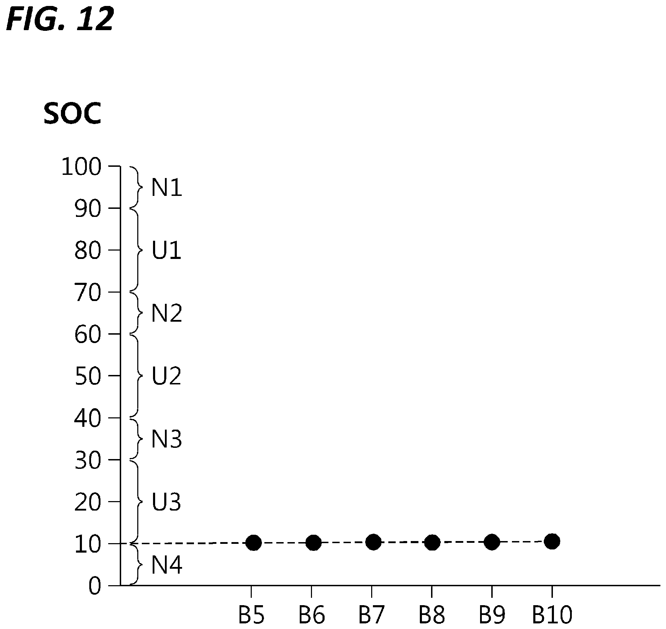

For example, in the Example of FIG. 12, the fifth battery B5 and the sixth battery B6 may be discharged. The fifth battery B5 and the sixth battery B6 may be 10 % SOC, which may be the same as the lower limit value of the third usable SOC band U3. That is, the SOCs of all of the fifth battery B5, the sixth battery B6, the seventh battery B7, the eighth battery B8, the ninth battery B9, and the tenth battery B10 may be the same at 10 % SOC.

During the charge process thereafter, the fifth battery B5 and the sixth battery B6 may be charged until their SOCs reach the upper limit value of the first usable SOC band U1, the seventh battery B7 and the eighth battery B8 may be charged until their SOCs reach the upper limit value of the second usable SOC band U2, and the ninth battery B9 and the tenth battery B10 may be charged until their SOCs reach the upper limit value of the third usable SOC band U3. Then, the control unit 120 may control the charge and discharge of the fifth battery B5 and the sixth battery B6 within the first usable SOC band U1. The control unit 120 may control the charge and discharge of the seventh battery B7 and the eighth battery B8 within the second usable SOC band U2. The control unit 120 may control the charge and discharge of the ninth battery B9 and the tenth battery B10 within the third usable SOC band U3.

The battery management apparatus 100 according to an embodiment of the present disclosure may control the charge and discharge of the plurality of batteries B, such that the plurality of batteries B degrade in equilibrium even when the discharge request is made continuously.

The control unit 120 may set equal intervals for the plurality of usable SOC bands.

If the intervals of the usable SOC bands are different from each other, the degradation of the batteries may become unbalanced according to the corresponding usable SOC bands.

For example, it may be assumed that the interval of an N-1-th usable SOC band is 30 % SOC, and the interval of an N-th usable SOC band is 40 % SOC. Here, the interval of the SOC band refers to an SOC range included in a usable SOC band, and may be calculated through the formula of a "lower limit value-an upper limit value."

In this case, batteries corresponding to the N-1-th usable SOC band may be charged and discharged within the interval of 30 % SOC, while batteries corresponding to the N-th usable SOC band may be charged and discharged within the interval of 40 % SOC. Since the intervals of the charge and discharge SOC bands differ among the plurality of batteries B, the batteries corresponding to the N-th usable SOC band may degrade more quickly than the batteries corresponding to the N-1-th usable SOC band.

Therefore, the battery management apparatus 100 sets equal intervals for the plurality of usable SOC bands, to prevent the unbalance in degradation of the plurality of batteries B.

The control unit 120 may set a different number of batteries to correspond to each of the plurality of usable SOC bands.

Preferably, the control unit 120 may be configured to set the number of batteries such that the larger the band value of a usable SOC band, the greater the number of batteries corresponding to the usable SOC band.

For example, in the Example of FIG. 8, when the number of the plurality of batteries B is increased, the number of batteries corresponding to each usable SOC band may be decreased in the order of the first usable SOC band U1, the second usable SOC band U2, and the third usable SOC band U3. For example, the number of batteries corresponding to the first usable SOC band U1 may be the largest, and the number of batteries corresponding to the third usable SOC band U3 may be the smallest.

The plurality of batteries B may be fully charged (100 % SOC) at the initial time, and discharged in accordance with their corresponding usable SOC bands. In this case, the batteries corresponding to the usable SOC band with the high band value pass through more non-usable SOC bands than the batteries corresponding to the usable SOC band with the high band value do. For example, in the Example of FIG. 8, the fifth battery B5 and the sixth battery B6 are discharged passing through only the first non-usable SOC band N1, whereas the seventh battery B7 and the eighth battery B8 are discharged passing through the first non-usable SOC band N1 and the second non-usable SOC band N2. Further, the ninth battery B9 and the tenth battery B10 are discharged passing through all of the first non-usable SOC band N1, the second non-usable SOC band N2, and the third non-usable SOC band N3. In this discharge stage, the ninth battery B9 and the tenth battery B10, which correspond to the third usable SOC band U3 with the low band value, may degrade more quickly than the other batteries. Thus, when more batteries are set to correspond to the usable SOC band with the high band value than the batteries corresponding to the usable SOC band with the low band value, the overall degradation degree of the plurality of batteries may decline.

Taking this point into consideration, the battery management apparatus 100 may set the number of batteries corresponding to the usable SOC bands to differ according to the band values of the usable SOC bands.

The battery management apparatus 100 according to the present disclosure may be applied to a battery management system (BMS). For example, a BMS according to the present disclosure may include the battery management apparatus 100 described above. In this configuration, at least a portion of the components of the battery management apparatus 100 may be implemented by enhancing or adding functions of components of a well-known BMS. For example, the measurement unit 110, the control unit 120, and the storage unit 130 of the battery management apparatus 100 may be implemented as components of a BMS.

Further, the battery management apparatus 100 according to the present disclosure may be provided in a battery pack 1. For example, the battery pack 1 according to the present disclosure may include the battery management apparatus 100 described above and one or more battery cells. The battery pack 1 may further include electric components (e.g., relays and fuses), a case and so on.

In the embodiment of FIG. 2, the positive terminal of each battery B may be connected to the positive terminal P+ of the battery pack 1, and the negative terminal of the battery B may be connected to the negative terminal P- of the battery pack 1.

An external device may be connected to the positive terminal P+ and the negative terminal P- of the battery pack 1. Thus, the positive terminal of the battery B, the positive terminal P+ of the battery pack 1, the external device, the negative terminal P- of the battery pack 1, and the negative terminal of the battery B may be electrically connected to each other.

For example, the external device may be a charging or discharging device, or a load such as a motor of an electric vehicle, which is powered from the plurality of batteries B.

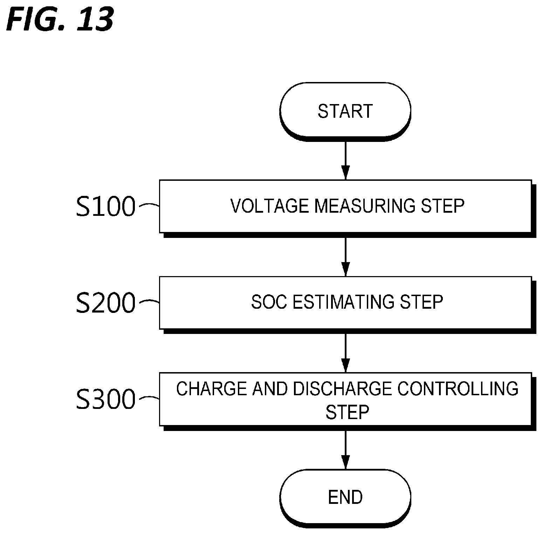

FIG. 13 is a flow diagram schematically illustrating a battery management method according to another embodiment of the present disclosure.

Each step of the battery management method may be performed by the battery management apparatus 100. Hereinafter, for the convenience of description, descriptions overlapping with the descriptions above will be omitted or summarized briefly.

Referring to FIG. 13, the battery management method may include a voltage measuring step (S100), an SOC estimating step (S200), and a charge/discharge controlling step (S300).

The voltage measuring step S 100 is a step of measuring voltages of the plurality of batteries B connected in series to each other, and may be performed by the measurement unit 110.

Specifically, the measurement unit 110 may measure the voltage of each of the plurality of batteries B. Then, the measurement unit 110 may transmit information of the measured voltage to the control unit 120.

The SOC estimating step S200 is a step of estimating the SOCs of the plurality of batteries B based on the voltages, and may be performed by the control unit 120.

Specifically, the control unit 120 may estimate the SOC of each of the plurality of batteries B by using the table representing the association relationship between voltages and SOCs.

The charge and discharge controlling step S300 is a step of controlling the charge and discharge of the plurality of batteries B, such that the SOCs of the plurality of batteries B fall within the plurality of usable SOC bands preset to correspond to the plurality of batteries B, and may be performed by the control unit 120.

Specifically, each of the plurality of batteries B may be preset to correspond to one of the plurality of usable SOC bands. Then, the control unit 120 may control the charge and discharge of the plurality of batteries B such that the SOCs of the plurality of batteries B fall in the corresponding usable SOC bands.

In the embodiment of FIG. 2, the control unit 120 may set a target battery of which SOC reaches the lower limit value of the corresponding usable SOC band, and control the operation state of the bypass switch S connected in parallel to the target battery to the ON state. In this case, the target battery may be excluded from the batteries subjected to the charge and discharge, so that the charge and discharge of the target battery may be stopped.

The embodiments of the present disclosure described above may not be limited to an apparatus and a method, but may also be implemented by programs that implement the functions corresponding to the components of the embodiments of the present disclosure, or a recording medium that stores the programs. The programs or recording medium may easily be implemented by one skilled in the field of the present disclosure from the descriptions of the embodiments above.

While the present disclosure has been described using the embodiments and the drawings, the present disclosure is not limited thereto. Various modifications and changes may be made by one of ordinary skill in the art to which the present disclosure belongs, within the scope equivalent to the technical idea of the present disclosure and the claims set forth below.

Further, since various substitutions, modifications, and changes may be made to the present disclosure by one of ordinary skilled in the art within the scope that does not depart from the technical idea of the present disclosure, the present disclosure is not limited by the foregoing embodiments and the drawings attached herewith, but all or some of the embodiments may be selectively combined to implement various modifications.

### List of Reference Numerals

1: battery pack
100: battery management apparatus
110: measurement unit
120: control unit
130: storage unit

## Claims

1. A battery management apparatus (100) comprising:
a voltage meter (110) configured to measure voltages of a plurality of batteries (B1, ...; B10) connected in series to each other; and
a controller (120) configured to estimate State of Charges, SOCs, of the plurality of batteries (B1, ..., b10) based on the voltages, and **characterized in that** the controller (120) is further configured to control charge and discharge of each of the plurality of batteries (B1, ...; B10) to make peach of the SOCs of the plurality of batteries (B1, ...; B10) fall within a plurality of usable SOC bands (U1, U2, U3) preset to correspond to the plurality of batteries (B1, ...; B10),
wherein the plurality of usable SOC bands (U1, U2, U3) are divided based on preset non-usable SOC bands (N1, ..., N4) and set to not overlap with each other.

2. The battery management apparatus according to claim 1, wherein the controller (120) is configured to control an operation state of a bypass switch (S1, ..., S4) disposed in a bypass path connected in parallel to each of the plurality of batteries (B1, ..., B10), to control the charge and discharge of the plurality of batteries (B1, ..., B10).

3. The battery management apparatus according to claim 2, wherein during the charge of the plurality of batteries (B1, ...; B10), the controller (120) is configured to select a target battery with an SOC reaching an upper limit value of a usable SOC band (U1, U2, U3) corresponding to the target battery, and to control the operation state of the bypass switch (S1, ..., S4) connected in parallel to the target battery to an ON state.

4. The battery management apparatus according to claim 2, wherein during the discharge of the plurality of batteries (B1, ...; B10), the controller (120) is configured to select a target battery with an SOC reaching a lower limit value of a usable SOC band (u1, U2, U3) corresponding to the target battery, and to control the operation state of the bypass switch (S1, ..., S4) connected in parallel to the target battery to an ON state.

5. The battery management apparatus according to claim 1, wherein when the plurality of batteries (B1, ..., B10) are requested to be discharged despite that the SOCs of the plurality of batteries (B1, ..., B10) have reached lower limit values of the usable SOC bands (U1, U2, U3) corresponding to the plurality of batteries (B1, ..., B10), the controller (120) is configured to set priorities among the plurality of usable SOC bands (U1, U2, U3) in a decreasing order of band values of the plurality of usable SOC bands (U1, U2, U3), and to discharge the plurality of batteries (B1, ..., B10) from batteries corresponding to a usable SOC band (U1, U2, U3) with a highest priority to batteries corresponding to a usable SOC band (U1, U2, U3) with a lowest priority.

6. The battery management apparatus according to claim 5, wherein when the SOCs of discharged batteries reach a lower limit value of a usable SOC band (U1, U2, U3) with a subsequent priority, the controller (120) is configured to discharge batteries corresponding to the usable SOC band (U1, U2, U3) with the subsequent priority.

7. The battery management apparatus according to claim 1, wherein the controller (120) is configured to set intervals of the plurality of usable SOC bands (U1, U2, U3) to be equal to each other.

8. The battery management apparatus according to claim 1, wherein the controller (120) is configured to set a different number of batteries to correspond to each of the plurality of usable SOC bands (U1, U2, U3).

9. The battery management apparatus according to claim 8, wherein the controller (120) is configured to set the different number of batteries such that the larger a band value of a usable SOC band (U12, U2, U3), the greater the number of batteries corresponding to the SOC band.

10. A battery pack comprising the battery management apparatus according to any one of claims 1 to 9.

11. A battery management method comprising:
measuring (S100) voltages of a plurality of batteries (B1, ...; B10) connected in series to each other;
estimating (S200) State of Charges, SOCs, of the plurality of batteries (B1, ...; B10) based on the voltages; and **characterized by**
controlling (S300) charge and discharge of each of the plurality of batteries (B1, ...; B10) to make each of the SOCs of the plurality of batteries (B1, ...; B10) fall within a plurality of usable SOC bands (U1, U2, U3) preset to correspond to the plurality of batteries (B1, ...; B10),
wherein the plurality of usable SOC bands (U1, U2, U3) are divided based on preset non-usable SOC bands (N1, ..., N4) and set to not overlap with each other.

## Patentansprüche

1. Batteriemanagementeinrichtung (100), umfassend:
einen Spannungsmesser (110), der konfiguriert ist, um Spannungen einer Vielzahl von Batterien (B1, ...; B10) zu messen, die in Reihe miteinander verbunden sind; und
eine Steuereinheit (120), die konfiguriert ist, um Ladezustände, SOCs, der Vielzahl von Batterien (B1, ..., B10) basierend auf den Spannungen zu schätzen, und **dadurch gekennzeichnet, dass** die Steuereinheit (120) weiter konfiguriert ist, um Laden Entladen jeder der Vielzahl von Batterien (B1, ...; B10) zu steuern, um zu bewirken, dass jeder der SOCs der Vielzahl von Batterien (B1, ...; B10) innerhalb einer Vielzahl von nutzbaren SOC-Bändern (U1, U2, U3) fällt, die voreingestellt sind, um der Vielzahl von Batterien (B1, ...; B10) zu entsprechen,
wobei die Vielzahl von nutzbaren SOC-Bändern (U1, U2, U3) basierend auf voreingestellten nicht nutzbaren SOC-Bändern (N1, ..., N4) unterteilt und eingestellt sind, um sich nicht gegenseitig zu überlappen.

2. Batteriemanagementeinrichtung nach Anspruch 1, wobei die Steuereinheit (120) konfiguriert ist, um einen Betriebszustand eines Bypass-Schalters (S1, ..., S4) zu steuern, der in einem Bypass-Pfad angeordnet ist, der parallel mit jeder der Vielzahl von Batterien (B1, ..., B10) verbunden ist, um das Laden und Entladen der Vielzahl von Batterien (B1, ..., B10) zu steuern.

3. Batteriemanagementeinrichtung nach Anspruch 2, wobei beim Laden der Vielzahl von Batterien (B1, ...; B10) die Steuereinheit (120) konfiguriert ist, um eine Zielbatterie mit einem SOC auszuwählen, der einen oberen Grenzwert eines nutzbaren SOC-Bandes (U1, U2, U3) erreicht, das der Zielbatterie entspricht, und um den Betriebszustand des Bypass-Schalters (S1, ..., S4), der parallel mit der Zielbatterie verbunden ist, in einen EIN-Zustand zu steuern.

4. Batteriemanagementeinrichtung nach Anspruch 2, wobei beim Entladen der Vielzahl von Batterien (B1, ...; B10) die Steuereinheit (120) konfiguriert ist, um eine Zielbatterie mit einem SOC auszuwählen, der einen unteren Grenzwert eines nutzbaren SOC-Bandes (u1, U2, U3) erreicht, das der Zielbatterie entspricht, und um den Betriebszustand des Bypass-Schalters (S1, ..., S4), der parallel mit der Zielbatterie verbunden ist, in einen EIN-Zustand zu steuern.

5. Batteriemanagementeinrichtung nach Anspruch 1, wobei, wenn angefordert wird, die Vielzahl von Batterien (B1, ..., B10) zu entladen, obwohl die SOCs der Vielzahl von Batterien (B1, ..., B10) untere Grenzwerte der nutzbaren SOC-Bänder (U1, U2, U3) erreicht haben, die der Vielzahl von Batterien (B1, ..., B10) entsprechen, die Steuereinheit (120) konfiguriert ist, um Prioritäten aus der Vielzahl von nutzbaren SOC-Bändern (U1, U2, U3) in einer absteigenden Reihenfolge von Bandwerten der Vielzahl von nutzbaren SOC-Bändern (U1, U2, U3) einzustellen, und um die Vielzahl von Batterien (B1, ..., B10) von Batterien, die einem nutzbaren SOC-Band (U1, U2, U3) mit einer höchsten Priorität entsprechen, bis zu Batterien zu entladen, die einem nutzbaren SOC-Band (U1, U2, U3) mit einer niedrigsten Priorität entsprechen.

6. Batteriemanagementeinrichtung nach Anspruch 5, wobei, wenn die SOCs von entladenen Batterien einen unteren Grenzwert eines nutzbaren SOC-Bandes (U1, U2, U3) mit einer nachfolgenden Priorität erreichen, die Steuereinheit (120) konfiguriert ist, um Batterien zu entladen, die dem nutzbaren SOC-Band (U1, U2, U3) mit der nachfolgenden Priorität entsprechen.

7. Batteriemanagementeinrichtung nach Anspruch 1, wobei die Steuereinheit (120) konfiguriert ist, um Intervalle der Vielzahl von nutzbaren SOC-Bändern (U1, U2, U3) einzustellen, um einander zu gleichen.

8. Batteriemanagementeinrichtung nach Anspruch 1, wobei die Steuereinheit (120) konfiguriert ist, um eine unterschiedliche Anzahl an Batterien einzustellen, um jedem der Vielzahl von nutzbaren SOC-Bändern (U1, U2, U3) zu entsprechen.

9. Batteriemanagementeinrichtung nach Anspruch 8, wobei die Steuereinheit (120) konfiguriert ist, um die unterschiedliche Anzahl an Batterien einzustellen, sodass je größer ein Bandwert eines nutzbaren SOC-Bandes (U1, U2, U3) ist, desto größer die Anzahl an Batterien ist, die dem SOC-Band entsprechen.

10. Batteriepack, umfassend die Batteriemanagementeinrichtung nach einem der Ansprüche 1 bis 9.

11. Batteriemanagementverfahren, umfassend:
Messen (S100) von Spannungen einer Vielzahl von Batterien (B1, ...; B10), die in Reihe miteinander verbunden sind;
Schätzen (S200) von Ladezuständen, SOCs, der Vielzahl von Batterien (B1, ...; B10) basierend auf den Spannungen; und **gekennzeichnet durch**
Steuern (S300) von Laden und Entladen jeder der Vielzahl von Batterien (B1, ...; B10), um zu bewirken, dass jeder der SOCs der Vielzahl von Batterien (B1, ...; B10) innerhalb einer Vielzahl von nutzbaren SOC-Bändern (U1, U2, U3) fällt, die voreingestellt sind, um der Vielzahl von Batterien (B1, ...; B10) zu entsprechen,
wobei die Vielzahl von nutzbaren SOC-Bändern (U1, U2, U3) basierend auf voreingestellten nicht nutzbaren SOC-Bändern (N1, ..., N4) unterteilt und eingestellt sind, um sich nicht gegenseitig zu überlappen.

## Revendications

1. Appareil de gestion de batterie (100) comprenant :
un voltmètre (110) configuré pour mesurer des tensions d'une pluralité de batteries (B1, ... ; B10) connectées en série les unes aux autres ; et
un contrôleur (120) configuré pour estimer des états de charge, SOC, de la pluralité de batteries (B1, ..., B10) sur la base des tensions, et **caractérisé en ce que** le contrôleur (120) est en outre configuré pour commander la charge et la décharge de chacune de la pluralité de batteries (B1, ... ; B10) pour faire en sorte que chacun des SOC de la pluralité de batteries (B1, ... ; B10) se situe dans une pluralité de bandes de SOC utilisables (U1, U2, U3) prédéfinies pour correspondre à la pluralité de batteries (B1, ... ; B10),
dans lequel la pluralité de bandes de SOC utilisables (U1, U2, U3) sont divisées sur la base de bandes de SOC non utilisables (N1, ..., N4) prédéfinies et réglées pour ne pas se chevaucher les unes les autres.

2. Appareil de gestion de batterie selon la revendication 1, dans lequel le contrôleur (120) est configuré pour commander un état de fonctionnement d'un commutateur de dérivation (S1, ..., S4) disposé dans un chemin de dérivation connecté en parallèle à chacune de la pluralité de batteries (B1, ..., B10), pour commander la charge et la décharge de la pluralité de batteries (B1, ..., B10).

3. Appareil de gestion de batterie selon la revendication 2, dans lequel pendant la charge de la pluralité de batteries (B1, ... ; B10), le contrôleur (120) est configuré pour sélectionner une batterie cible avec un SOC atteignant une valeur limite supérieure d'une bande de SOC utilisable (U1, U2, U3) correspondant à la batterie cible, et pour commander l'état de fonctionnement du commutateur de dérivation (S1, ..., S4) connecté en parallèle à la batterie cible à un état MARCHE.

4. Appareil de gestion de batterie selon la revendication 2, dans lequel pendant la décharge de la pluralité de batteries (B1, ... ; B10), le contrôleur (120) est configuré pour sélectionner une batterie cible avec un SOC atteignant une valeur limite inférieure d'une bande de SOC utilisable (u1, U2, U3) correspondant à la batterie cible, et pour commander l'état de fonctionnement du commutateur de dérivation (S1, ..., S4) connecté en parallèle à la batterie cible à un état MARCHE.

5. Appareil de gestion de batterie selon la revendication 1, dans lequel, lorsqu'il est demandé de décharger la pluralité de batteries (B1, ..., B10) bien que les SOC de la pluralité de batteries (B1, ..., B10) aient atteint des valeurs limites inférieures des bandes de SOC utilisables (U1, U2, U3) correspondant à la pluralité de batteries (B1, ..., B10), le contrôleur (120) est configuré pour définir des priorités parmi la pluralité de bandes de SOC utilisables (U1, U2, U3) dans un ordre décroissant de valeurs de bande de la pluralité de bandes de SOC utilisables (U1, U2, U3), et pour décharger la pluralité de batteries (B1, ..., B10) à partir des batteries correspondant à une bande de SOC utilisable (U1, U2, U3) avec une priorité la plus élevée jusqu'aux batteries correspondant à une bande de SOC utilisable (U1, U2, U3) avec une priorité la plus basse.

6. Appareil de gestion de batterie selon la revendication 5, dans lequel, lorsque les SOC de batteries déchargées atteignent une valeur limite inférieure d'une bande de SOC utilisable (U1, U2, U3) avec une priorité suivante, le contrôleur (120) est configuré pour décharger les batteries correspondant à la bande de SOC utilisable (U1, U2, U3) avec la priorité suivante.

7. Appareil de gestion de batterie selon la revendication 1, dans lequel le contrôleur (120) est configuré pour régler des intervalles de la pluralité de bandes de SOC utilisables (U1, U2, U3) pour qu'ils soient égaux les uns aux autres.

8. Appareil de gestion de batterie selon la revendication 1, dans lequel le contrôleur (120) est configuré pour régler un nombre différent de batteries pour correspondre à chacune de la pluralité de bandes de SOC utilisables (U1, U2, U3).

9. Appareil de gestion de batterie selon la revendication 8, dans lequel le contrôleur (120) est configuré pour régler le nombre différent de batteries de telle sorte que plus une valeur de bande d'une bande de SOC utilisable (U1, U2, U3) est grande, plus le nombre de batteries correspondant à la bande de SOC est grand.

10. Bloc-batterie comprenant l'appareil de gestion de batterie selon l'une quelconque des revendications 1 à 9.

11. Procédé de gestion de batterie comprenant :
la mesure (S100) de tensions d'une pluralité de batteries (B1, ... ; B10) connectées en série les unes aux autres ;
l'estimation (S200) d'états de charge, SOC, de la pluralité de batteries (B1, ... ; B10) sur la base des tensions ; et **caractérisé par**
la commande (S300) de la charge et de la décharge de chacune de la pluralité de batteries (B1, ... ; B10) pour faire en sorte que chacun des SOC de la pluralité de batteries (B1, ... ; B10) se situe dans une pluralité de bandes de SOC utilisables (U1, U2, U3) prédéfinies pour correspondre à la pluralité de batteries (B1, ... ; B10),
dans lequel la pluralité de bandes de SOC utilisables (U1, U2, U3) sont divisées sur la base de bandes de SOC non utilisables (N1, ..., N4) prédéfinies et réglées pour ne pas se chevaucher les unes les autres.
